# EUROPEAN PATENT APPLICATION

(11) **EP 2 889 928 A1**
(43) Date of publication of application: **01.07.2015**
(21) Application number: 13199538.3
(22) Date of filing: 24.12.2013
(51) Int. Cl.: H01L 51/40, H01L 51/42

(54) **Improved photoactive compositions**

(71) Applicant: Solvay SA, 1120 Bruxelles (BE)
(72) Inventor: Madec, Marie-Béatrice, 1030 Brussels (BE)
(74) Representative: Vande Gucht, Anne

(57) **Abstract**

Photoactive composition comprising an organic semiconducting material consisting of either (i) at least one p-type semiconducting material or (ii) at least one n-type semiconducting material or (iii) at least one p-type semiconducting material and at least one n-type semiconducting material in a solvent system, wherein the composition contains at least one organic substance (S) containing at least two C₂-C₁₀ oxyalkylene moieties other than a sorbitan ester.

## Description

The present invention relates to improved photoactive compositions.

Photovoltaic devices based on organic materials are the subject of intensive research and development efforts. Compared to silicon-based solar cells, which are the primary technology in the current solar cell and photovoltaic devices market, these systems offer great potential for cost savings as conventional printing or comparable processes could be used for the manufacture of the photovoltaic device.

Conductive polymers are a key component of these new systems. They can be manufactured in industrial sized reactors - similar to plastics manufacturing processes - and can be solution processed to form films or may be printed by standard printing techniques.

Another advantage of conductive polymer solar cell technology is the flexible and light weight design of the devices.

To be suitable for printing or coating techniques, the conductive polymers have to be formulated into suitable compositions which can be processed using conventional techniques without detrimentally changing the active components of the composition.

Useful compositions for the manufacture of the photoactive layer of a photovoltaic device usually comprise at least one p-type semiconducting material and at least one n-type semiconducting material in a solvent or a solvent composition.

Zhang et al., Appl. Phys. Lett. 90, 183512 (2007) describe polymeric photovoltaic devices from regioregular poly(3-hexylthiophene-2,5-diyl, P3HT) and [6,6] phenyl-C61-butyric acid methyl ester (PCBM) processed in the presence of oleic acid. The devices thus obtained showed improved power conversion efficiency compared to devices which had been obtained without oleic acid.

Kim et al., J. Mater. Chem. 2010, 20, 7710 study the properties P3HT:PCBM photovoltaic devices in dependence of the weight ration of P3HT to PCBM.

Yeates et al., J. Mater. Chem. 2010, 20, 9155 study the reproducibility of inkjet printed organic thin film transistors based on solution processible polymer/small molecule blends.

Originally, photoactive compositions useful in the manufacture of organic photovoltaic devices were mostly based on halogenated, in particular chlorinated solvents as these were often the only solvents for the polymers. For environmental and health safety reasons, halogenated solvents are not preferred and thus other solvent systems have been developed to reduce or avoid the use of halogenated solvents.

WO 2008/137468 discloses a solvent system for conjugated polymers useful as components in a photovoltaic device. The compositions disclosed and claimed comprise at least one conjugated polymer, at least one first solvent and at least one second solvent, wherein the second solvent is different from the first solvent and wherein the second solvent comprises a thiophene ring.

Unfortunately the efficiency of photovoltaic devices obtained using such systems is not as good as the respective devices obtained from compositions based on halogenated solvents. Without being bound to any theory it may be assumed that the problems observed could be at least partly due to the solvent evaporating too fast and potentially detrimentally influencing the morphology of the systems.

Due to a tendency to phase separate at low concentrations, comparatively high polymer concentrations have to be used which sometimes results in gel-like compositions which have to be warmed prior to their use, which is again undesirable and bears the risk of decomposition or change in decomposition.

Thus, there still is a need to provide photoactive compositions useful for the manufacture of organic photovoltaic devices which avoid the above disadvantages or where at least these disadvantages are reduced.

It was thus an object of the present invention to provide photoactive compositions useful for the manufacture of organic photovoltaic devices which can be processed by conventional printing, spraying or coating techniques to yield devices with a good performance in a cost-effective and simple manner.

This object has been achieved by the photoactive compositions in accordance with claim 1. Preferred compositions in accordance with the present invention are set forth in the dependent claims and the detailed description hereinafter.

The photoactive compositions in accordance with the present invention comprise an organic semiconducting material consisting of either (i) at least one p-type semiconducting material or (ii) at least one n-type semiconducting material or (iii) at least one p-type semiconducting material and at least one n-type semiconducting material in a solvent system, and at least one organic substance (S) containing at least two C₂-C₁₀ oxyalkylene moieties other than a sorbitan ester.

Otherwise said, the photoactive compositions in accordance with the present invention can be defined as compositions comprising
- an organic semiconducting material consisting of either (i) at least one p-type semiconducting material or (ii) at least one n-type semiconducting material or (iii) at least one p-type semiconducting material and at least one n-type semiconducting material,
- a solvent system, and
- at least one organic substance (S) containing at least two C₂-C₁₀ oxyalkylene moieties other than a sorbitan ester.

The amount of the organic substance (S) may vary to a large extent, and will be easily optimized by the skilled person, notably depending on the chemical nature of the non-oxyalkylene moieties of which the organic substance (S) may be composed (if any). The amount of the organic substance (S) ranges usually from 0.01 wt.% to 100 wt.%, based on the weight of the semiconducting material. The amount of the organic substance (S), based on the weight of the semiconducting material, can be of at least 0.1 wt.%, at least 0.2 wt. %, at least 0.5 wt. %, at least 1 wt%, at least 2 wt.%, at least 5 wt.% or at least 10 wt.%, based on the weight of the semiconducting material. Besides, the amount of the organic substance (S), based on the weight of the semiconducting material, can be of at most 50 wt. %, at most 20 wt. %, at most 10 wt. %, at most 5 wt. %, at most 2 wt.% or at most 1 wt.%, based on the weight of the semiconducting material. Any ranges of values for the amount of the organic substance (S) obtained by combining any above cited lower limit with any above cited upper limit should be considered as herein clearly and unambiguously described. In particular, when the organic substance (S) is a non ionic emulsifier, good results are notably obtained when the amount of the organic substance (S) ranges from 15 to 85 wt.%, preferably from 25 to 50 wt.%, based on the weight of the semiconducting material. When the organic substance (S) is an emulsifier, good results may be achieved with lower amounts, let us for example from 0.5 wt.% to 5 wt. %, based on the weight of the semiconducting material.

The photoactive compositions in accordance with the instant invention comprise an organic substance (S) which contains at least two C₂-C₁₀ oxyalkylene moieties.

Said organic substance (S) differs from a sorbitan ester, especially from an alkoxylated sorbitan ester. Indeed, photoactive compositions containing sorbitan esters, in particular alkoxylated sorbitan esters, are intended to be distinctly protected by the Applicant.

For the avoidance of doubt, an oxyalkylene moiety (also referred to as "alkylene oxide" moiety) is intended to denote a divalent moiety of formula -p-O- wherein p is alkylene. In the at least two C₂-C₁₀ oxyalkylene moieties contained in the organic substance (S), p is C₂-C₁₀ alkylene. Divalent group p can be linear or ramified. In organic substances (S), it is preferred that divalent group p be linear. Divalent group p is preferably a C₂-C₆ group, such as n-hexylene, n-pentylene, n-butylene, n-propylene or ethylene. It is more preferably selected from the group consisting of n-propylene (-CH₂-CH₂-CH₂-), ethylene (-CH₂-CH₂-) and mixtures thereof. Still more preferably, it is ethylene, and the corresponding oxyalkylene moiety is known as ethylene oxide or oxyethylene (-CH₂-CH₂-O-).

The total number of oxyalkylene moieties in the organic substance (S) may vary to a large extent, and will be easily optimized by the skilled person depending on the chemical nature of the non-oxyalkylene moieties of which the organic substance (S) may be composed, if any. The total number of oxyalkylene moieties in the organic substance (S) can be of at least 4, at least 6, at least 8, at least 12, at least 16, at least 20, at least 50, at least 200 or at least 1000. Besides, the total number of oxyalkylene moieties in the organic substance (S) can be of at most 5000, at most 1000, at most 200, at most 50, at most 20, at most 16, at most 12 or at most 8. Any ranges of values for the total number of oxyalkylene moieties in the organic substance (S) obtained by combining any above cited lower limit with any above cited upper limit should be considered as herein clearly and unambiguously described.

Polymers, including oligomers, represent suitable choices for the substance (S). They are typically available in the form of a polymeric material having a certain degree of polydispersity (the polydispersity index is generally defined as the ratio of the weight average molecular weight to the number average molecular weight of a polymer), composed of a plurality of substances (S) differing from each other by their unique, single number of oxyalkylene recurring units -p-O-. When (S*) denotes a preferred substance (S) having a molecular weight of e.g. at most 1,500, it will be understood that a poly(ethylene oxide) material having a number average molecular weight of e.g. 1,750, because of its polydispersity, might, for example, contain a certain amount of poly(ethylene oxide) substances (S*) having individually a molecular weight of at most 1,500.

The molecular weight distribution of a material exhibiting a certain degree of polydispersity, in particular of a polymeric material such as a poly(alkylene oxide) material, can be easily determined by Gel Permeation Chromatography using a Jordi DVB Glucose BR Mixed Bed Linear packing column with a length (L) of 50 cm and an inner diameter (I.D.) of 10 mm, a refractive index detector, DMSO as the solvent, a flow rate of 1.0 mL/min, a temperature of 80°C and polystyrene or poly(ethylene oxide) calibration standards. When the substance (S) is a plurality of substances composing a material exhibiting a certain degree of polydispersity, in particular of a polymeric material such as a poly(alkylene oxide) material, it is advantageously characterized by its number and/or its weight average molecular weight (methods for the determination of weight and number average molecular weights are known to the skilled man).

The number average or the weight average molecular weight of a substance (S) suitable for use in the polymer compositions in accordance with the instant invention is advantageously at least 100; it is preferably of at least 200, more preferably of at least 300, still more preferably of at least 400. Besides, the number average or the weight average molecular weight of such a substance (S) may be generally of at most 20,000,000, at most 10,000,000, at most 8,000,000, at most 5,000,000, at most 500,000, at most 200,000, at most 100,000, at most 50,000, at most 20,000, at most 10,000, at most 5,000 or at most 2,000.

The preferred molecular weight may depend to a certain degree on the nature of substance (S). In some cases, notably when the substance (S) is a cationic, anionic or non ionic emulsifier, good results can be obtained with substances S the number average or the weight average molecular weight of which is of at most 1,500, at most 1,000 or at most 750. In other cases, notably when the substance (S) is a poly(alkylene oxide) homopolymer or a poly(alkylene oxide) copolymer of which all the repeating units are derived from alkylene oxide monomers, good results are obtained with substances S the number average or the weight average molecular weight of which is of at least 2,000, at least 10,000 or at least 100,000.

The substance (S) may contain from 0 up to at most 4, at most 3, at most 2 or at most 1 carbon atom(s) other than the carbon atoms contained in its oxyalkylene units -p-O-. The substance (S) may be essentially free or completely free of carbon atoms other than the carbon atoms contained in its oxyalkylene units -p-O-. The hereinafter described poly(alkylene oxide)s often meet these features.

Alternatively, the substance (S) may further contain at least 6, at least 8, at least 10, at least 12, at least 14, at least 16, at least 18 or at least 20 carbon atoms other than the carbon atoms contained in its oxyalkylene units -p-O-; the hereinafter described emulsifiers often meet these features. In this case, the substance (S) may contain carbon atoms other than the carbon atoms contained in its oxyalkylene units -p-O- in an amount not exceeding 40, 30, 25, 20, 18 or 16 carbon atoms.

The substance (S) is advantageously free of ethylenic unsaturation. Preferably, the substance (S) contains only fully saturated C-C bonds and no C-C double or triple bonds.

The substance (S) may consist essentially of or consist of hydrophilic -p-O- oxyalkylene units.

### First class of substances (S). Poly(alkylene oxide)s

Then, a first class of substances (S) of interest in accordance with the present invention lies in the so called "poly(alkylene oxide)s". Poly(alkylene oxide)s suitable for use in the present invention are polymers essentially all or all the repeating units of which comply with general formula -p-O- wherein p represents a divalent alkylene group having from 2 to 10 carbon atoms. Such poly(alkylene oxide)s may be terminated by a hydroxyl group. Particularly suitable poly(alkylene oxide)s are those wherein p has from 2 to 4 carbon atoms, preferably from 2 to 3 carbon atoms, more preferably 2 carbon atoms. The poly(alkylene oxide)s may be either linear or branched. Linear poly(alkylene oxides) are generally preferred.

Specific examples of suitable poly(alkylene oxide)s include polyoxyalkylene polyols, such as polyoxyethylene glycol (also known as poly(ethylene glycol) or poly(ethylene oxide), polyoxyethylene triol, polyoxyethylene tetraol, polyoxypropylene glycol (also commonly referred to as poly(propylene glycol) or poly(propylene oxide), polyoxypropylene triol, polyoxypropylene tetraol, polyoxybutylene glycol, , polyoxypentane glycol, polyoxyhexane glycol, polyoxyheptane glycol, and polyoxyoctane glycol. These polymers may be used either individually or in combinations of two or more; for example, it can be cited random copolymers of ethylene oxide and propylene oxide, and poly(ethylene oxide)-poly(propylene oxide) block copolymers.

The hydroxyl end groups of the poly(alkylene oxide)s may according to a preferred embodiment be partly or fully substituted by alkoxide groups, preferably methoxy or alkoxy. Methods for converting hydroxyl groups of poly(alkylene oxide)s into alkoxy groups are known to the skilled man and described in the literature.

Certain suitable oxyalkylene-containing compounds suitable as the substance (S) in the compositions in accordance with the instant invention are amine-terminated poly(alkylene oxide)s, in particular amine-terminated poly(ethylene oxide)s or amine-terminated poly(propylene oxide)s, including copolymers comprising both mentioned types of oxyalkylene units which are commercially available under the tradename Jeffamine^{®} from Huntsman Chemical Corporation.

The molecular weight of the poly(alkylene oxide)s in accordance with this embodiment may cover a wide range as discussed above generally for the substances S. In certain cases poly(alkylene oxide)s having a number average or weight average molecular weight of at least 20,000, preferably at least 200,000 and even more preferably at least 1,000,000 are advantageous. In other cases average molecular weights of at most 20,000, preferably at most 10,000 and even more preferably at most 1000 are useful. The molecular weight of the poly(alkylene oxides) suitable may also be optimized in view of the processing parameters or the operating conditions of photovoltaic devices. For example, a methoxy-terminated poly(ethylene oxide) having a number average or a weight average molecular weight of at most 2,000 may be used. Copolymers comprising oxyethylene and oxypropylene units in random or block distribution may also be suitable and respective products are commercially available under the tradename Pluronics^{®} from BASF.

Alternatively, the substance (S) can consist essentially of or consist of at least one hydrophilic block and at least one lipophilic block. The case being, the substance (S) comprises advantageously up to four hydrophilic first blocks and up to four lipophilic blocks. Possibly, the substance (S) comprises 1 or 2 hydrophilic first blocks and 1 or 2 lipophilic blocks. Many substances (S) in accordance with the present invention have one and only one hydrophilic first block and one and only one lipophilic block. Certain substances among such substances (S) may qualify as emulsifiers.

Emulsifiers are a group of surfactants, which latter compounds are generally considered to embrace compounds that lower the surface tension of a liquid, the interfacial tension between two liquids, or that between a liquid and a solid; surfactants may act as detergents, wetting agents, emulsifiers, foaming agents, and dispersants. An emulsifier is generally a compound used to keep mixtures of immiscible fluids well dispersed. An emulsifier positions advantageously itself with its hydrophilic and hydrophobic parts of the molecule at the interface of the immiscible fluids thus preventing clumping of the molecules of the fluids. Emulsifiers can thus be defined as compounds which, when added to a mixture of water and oil, are capable of forming an oil-in-water emulsion and/or a water-in-oil emulsion, depending on the respective proportions of water and oil present in the emulsion. Emulsifiers, when added to water at a concentration exceeding a certain concentration named "critical micellar concentration", are usually capable of forming micelles.

The substance (S) substance (S) may be a non ionic emulsifier, an anionic emulsifier, a cationic emulsifier or an amphoteric emulsifier.

The substance (S) can be notably selected from the group consisting of alkoxylated acyclic carboxylic acids, alkoxylated acyclic carboxylic acid esters, alkoxylated acyclic carboxylates, alkoxylated acyclic partially fluorinated carboxylic acids, alkoxylated perfluorinated carboxylic acids, alkoxylated acyclic alcohols, alkoxylated partially fluorinated acyclic alcohols, alkoxylated acyclic perfluoroalcohols, alkoxylated alkyl phenols, alkoxylated acyclic amines, alkoxylated partially fluorinated acyclic amines, alkoxylated acyclic perfluoroamines, alkoxylated acyclic amides, alkoxylated alkyl sulfates, alkoxylated partially fluorinated alkyl sulfates, alkoxylated perfluorinated alkyl sulfates, alkoxylated alkyl sulfonates, alkoxylated partially fluorinated alkyl sulfonates, alkoxylated perfluorinated alkyl sulfonates, alkoxylated alkylaryl sulfonates, alkoxylated mono- or dialkyl sulfosuccinates and sulfosuccinamates, alkoxylated mono- or dialkyl phosphates and alkylaryl phosphates.

In all the salts cited in the former paragraph, the one or more countercations, as the need may be, can be ammonium or an alkali metal, such as Na, Li or F.

Second class of substances (S). Non ionic emulsifiers

The substance (S) may be an non ionic emulsifier (free of ionic groups).

The total number of oxyalkylene units in the non ionic emulsifiers in accordance with the present invention is generally in the range of from 2 to 50. It can range from 3 to 25, from 4 to 12, from 2 to 10, from 2 to 6, from 10 to 50 or from 10 to 35.

A first subclass of non ionic emulsifiers of interest in accordance with the present invention lies in alkoxylated alcohols.

Usually, alkoxylated alcohols comply with the general formula

Z-O-(ρ-O)_{y}-H

wherein Z is C₆-C₃₀ hydrocarbyl, p is C₂-C₁₀ alkylene (for example -CH₂-CH₂-, -CH₂-CH₂-CH₂- or a mixture thereof) and y ranges from 2 to 50.

Preferably, alkoxylated alcohols are of formula

(1) R-O-(ρ-O)_{y}-H

wherein R is C₈-C₂₀alkyl or C₈-C₂₀alkenyl (such as oleyl), p is C₂-C₁₀ alkylene (for example -CH₂-CH₂-, -CH₂-CH₂-CH₂- or a mixture thereof) and y ranges from 2 to 50, or

R-ϕ-O-(ρ-O)_{y}-H (2)

wherein R is C₄-C₂₀alkyl (in particular, R is octyl or nonyl), ϕ is p-phenylene, p is C₂-C₁₀ alkylene (for example -CH₂-CH₂-, -CH₂-CH₂-CH₂- or a mixture thereof) and y ranges from 2 to 50.

Similar alcohols can be obtained by replacing R-ϕ in the above formula by [2,4-6-tri-(t-butyl)]-phenyl.

Examples of alkoxylated alcohols suitable as the substance (S) are the condensation products of from 2 to 50 moles of at least one C₂-C₃ alkylene oxide (such as ethylene oxide) with a mole of an ethylenically saturated or unsaturated fatty alcohol, especially a C₈-C₂₀alcohol chosen from lauryl alcohol, myristyl alcohol, palmityl alcohol, stearyl alcohol, oleyl alcohol, linoleyl alcohol, linolenyl alcohol, oxoalcohols and mixtures thereof. Other examples of alkoxylated alcohols suitable as the substance (S) are the condensation products of from 2 to 50 moles of at least one C₂-C₃ alkylene oxide (such as ethylene oxide) with a mole of n-octylphenol, n-nonylphenol and mixtures thereof. Alcoxylated alcohols are commercially available under the tradenames Brij^{®}, Genapol^{®} and Lutensol^{®} from Atlas Chemical Co., Clariant and BASF, respectively.

A second subclass of non ionic emulsifiers of interest in accordance with the present invention lies in alkoxylated oils and fats. This subclass essentially covers ethoxylated and/or propoxylated derivatives of lanolin (wool fat) or of castor oil. Lanolin is the generic name of a wax containing a mixture of esters and polyesters of high-molecular-weight alcohols and fatty acids. Castor oil is a mixture of a triglyceride of fatty acids.

A third subclass of non ionic emulsifiers of interest in accordance with the present invention lies in alkoxylated alkanolamides. This subclass includes:

- alkoxylated monoalkanolamides, which are typically of formula

R-C(=O)-NH-(p-O)_{y}-H

wherein R is C₈-C₂₀alkyl or C₈-C₂₀ alkenyl (such as oleyl), p is C₂-C₁₀ alkylene (for example -CH₂-CH₂-, -CH₂-CH₂-CH₂- or a mixture thereof) and y ranges from 2 to 50;

- dialkoxylated dialkanolamides, which are typically of formula 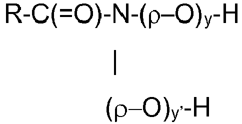 wherein R is C₈-C₂₀alkyl or C₈-C₂₀alkenyl (such as oleyl), ρ is C₂-C₁₀ alkylene (for example -CH₂-CH₂-, -CH₂-CH₂-CH₂- or a mixture thereof) and y and y' independently from each other range from 2 to 50.

A fourth subclass of non ionic emulsifiers of interest in accordance with the present invention lies in alkoxylated acids. This subclass includes monoesters and diesters.

Usually, monoesters comply with the general formula

Z-C(=O)-O-(ρ-O)_{y}-H

wherein Z is C₆-C₃₀ hydrocarbyl, p is C₂-C₁₀ alkylene (for example -CH₂-CH₂-, -CH₂-CH₂-CH₂- or a mixture thereof) and y ranges from 2 to 50.
Preferably, monoesters comply with the formula

R-C(=O)-O-(ρ-O)_{y}-H

wherein R is C₈-C₂₀alkyl or C₈-C₂₀alkenyl, p is C₂-C₁₀ alkylene (for example -CH₂-CH₂-, -CH₂-CH₂-CH₂- or a mixture thereof) and y ranges from 2 to 50.

Examples of alkoxylated acids monoesters are the condensation products of from 2 to 50 moles (in particular, from 4 to 16 moles) of an alkylene oxide (such as ethylene oxide) with one mole of a saturated or unsaturated fatty acid chosen from lauric acid, myristic acid, palmitic acid, stearic acid, oleic acid, linoleic acid and linolenic acid. An example thereof is Deplastol^{®} product which is a condensate of about 4-5 mol oxyethylene units with lauric acid and/or myristic acid. Deplastol^{®} is available from Cognis. Corresponding propoxylated and/or butylated fatty acids may also be included in the organic substance (S).

Usually, diesters comply with the general formula

Z-C(=O)-O-(ρ-O)_{y}-C(=O)-O-Z'

wherein Z and Z' are independently a C₆-C₃₀ hydrocarbyl, p is C₂-C₁₀ alkylene (for example -CH₂-CH₂-, -CH₂-CH₂-CH₂- or a mixture thereof) and y ranges from 2 to 50. Preferably, diesters comply with the formula

R-C(=O)-O-(ρ-O)_{y}-C(=O)-O-R'

wherein R and R' are independently C₈-C₂₀alkyl or C₈-C₂₀alkenyl, p is C₂-C₁₀ alkylene (for example -CH₂-CH₂-, -CH₂-CH₂-CH₂- or a mixture thereof) and y ranges from 2 to 50.

A fifth subclass of non ionic emulsifiers of interest in accordance with the present invention lies in alkoxylated glycol and glycerol esters. This subclass includes:
(1) alkoxylated ethylene glycol esters of formula

   R-C(=O)-O-CH₂-CH₂-O-(ρ-O)_{y}-H

   wherein R is C₈-C₂₀alkyl or C₈-C₂₀alkenyl, p is C₂-C₁₀ alkylene (for example -CH₂-CH₂-, -CH₂-CH₂-CH₂- or a mixture thereof) and y ranges from 2 to 50,
(2) alkoxylated propylene glycol esters of formula

   R-C(=O)-O-CH₂-CH(-CH₃)-O-(ρ-O)_{y}-H

   wherein R is C₈-C₂₀alkyl or C₈-C₂₀alkenyl, p is C₂-C₁₀ alkylene (for example -CH₂-CH₂-, -CH₂-CH₂-CH₂- or a mixture thereof) and y ranges from 2 to 50,
(3) alkoxylated esters of monoglycerides, and dialkoxylated esters of diglycerides, trialkoxylated esters of triglycerides, wherein said esters are the reaction products of glycerol or the like with a carboxylic acid comprising from 8 to 20 carbon atoms and comprise in total from 6 to 60 oxyalkylene units.

A sixth subclass of non ionic emulsifiers of interest in accordance with the present invention lies in ether carboxylic acids of formula

R-O-(ρ-O)_{y}-CH₂-COOH

wherein R is C₈-C₂₀ alkyl or C₈-C₂₀alkenyl (such as oleyl), p is C₂-C₁₀ alkylene (for example -CH₂-CH₂-, -CH₂-CH₂-CH₂- or a mixture thereof) and y ranges from 2 to 50.

A seventh subclass of non ionic emulsifiers of interest in accordance with the present invention lies in alkoxylated amines. This subclass includes:

- dialkoxylated primary amines of formula 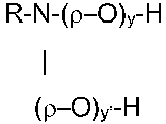 wherein R is C₈-C₂₀ alkyl or C₈-C₂₀alkenyl (such as oleyl), ρ is C₂-C₁₀ alkylene (for example -CH₂-CH₂-, -CH₂-CH₂-CH₂- or a mixture thereof) and y and y' range independently from 2 to 50;

- monoalkoxylated secondary amines of formula 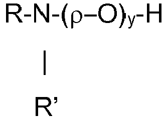 wherein R and R' independently are C₈-C₂₀ alkyl or C₈-C₂₀alkenyl (such as oleyl), p is C₂-C₁₀ alkylene (for example -CH₂-CH₂-, -CH₂-CH₂-CH₂- or a mixture thereof) and y ranges from 2 to 50.

A last subclass of non ionic emulsifiers of interest in accordance with the present invention lies in fluorosurfactants. In general, fluorosurfactants may be characterized by a content of fluorine in the molecule which might either arise from the copolymerization of a partially or fully fluorinated alkylene oxide with a non-fluorinated alkylene oxide or by reaction of fluorine containing reactants with poly(alkylene oxides) thus providing endgroups with a fluorine content. In the first case the oligomer or polymer comprises, in addition to the oxyalkylene groups, a certain amount of respective groups having one or more fluorine atom, i.e. in the case of ethylene oxide as the alkylene oxide these compounds comprise units -(CH₂-CH₂-O)- and units -(CH₂₋ₐXₐ-CH_{2-b}X_{b}-O)- where X represents fluorine and at least one of a or b is at least one.

In certain cases, fluorosurfactants of the general structure

F(CF₂-CF₂)ₓ- CH₂-CH₂-O-(CH₂-CH₂-O)_{y}-R

wherein R is H or an alkoxy group and x and y have a value in the range of from 1 to 50, preferably in the range of from 1 to 30 and particularly preferred x and y are at most 20, have proven advantageous. Products of this type having a number or weight average molecular weight of at most 2000, preferably at most 1500 and even more preferably at most 1000 have shown especially good results. The ratio of x vs. y is not subject to specific restrictions and may be selected within a wide range. A number of fluorosurfactants of this type is available from DuPont under the tradename Zonyl^{®}.

Another group of compounds suitable as the substance (S) include fluorosurfactants based on short chain molecules having six or less groups CF₂ and terminated at one end with fluorine and bound to a delivery system such as a polymer or surfactant as commercially available from Du Pont under the tradename name Capstone^{®}.

### Third class of substances (S). Ionic emulsifiers

Ionic emulsifiers (including anionic emulsifiers, cationic emulsifiers and amphoteric emulsifiers) suitable as the substance (S) comprise generally at least one non ionic moiety which consists of one or more C₂-C₄ oxyalkylene units, preferably oxyethylene and/or oxypropylene units, and more preferably oxyethylene units. The total number of oxyalkylene units in the ionic emulsifiers (including anionic emulsifiers, cationic emulsifiers and amphoteric emulsifiers) in accordance with the present invention is generally in the range of from 2 to 50. It can range from 3 to 25, from 4 to 12, from 2 to 10, from 2 to 6, from 10 to 50 or from 10 to 35.

The substance (S) may be an anionic emulsifier.

Then, a first subclass of ionic emulsifiers of interest in accordance with the present invention lies in alkoxylated carboxylates (also known as "ether carboxylates) of formula

R-O-(ρ-O)_{y}-CH₂-COOX

wherein R is C₈-C₂₀ alkyl or C₈-C₂₀ alkenyl (such as oleyl), p is C₂-C₁₀ alkylene (for example -CH₂-CH₂-, -CH₂-CH₂-CH₂- or a mixture thereof), X is ammonium or an alkali metal and y ranges from 2 to 50.

A second subclass of ionic emulsifiers of interest in accordance with the present invention lies in ester carboxylates of a di- or tricarboxylic acid, and are obtainable by the condensation reaction of an alcohol with the di- or tricarboxylic acid (e.g. glycolic acid or citric acid), wherein the alcohol has been previously alkoxylated. As examples thereof, the following two citrates can be cited:

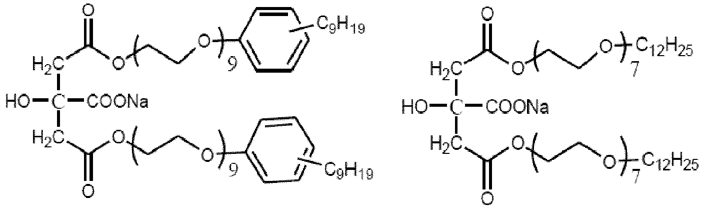

A third subclass of ionic emulsifiers of interest in accordance with the present invention lies in alkoxylated sulfonates (also known as ether sulfonates) of formula

R-O-(p-O)_{y}-CH₂-SO₃X

wherein R is C₈-C₂₀ alkyl or C₈-C₂₀alkenyl (such as oleyl), p is C₂-C₁₀ alkylene (for example -CH₂-CH₂-, -CH₂-CH₂-CH₂- or a mixture thereof), X is ammonium or an alkali metal and y ranges from 2 to 50.

A fourth subclass of ionic emulsifiers of interest in accordance with the present invention lies in alkoxylated sulfates (also known as ether sulfates). This class includes alkyl or alkenyl ether sulfates of formula

R-O-(ρ-O)_{y}-SO₃X

wherein R is C₈-C₂₀ alkyl or alkenyl (such as oleyl), p is C₂-C₁₀ alkylene (for example -CH₂-CH₂-, -CH₂-CH₂-CH₂- or a mixture thereof), X is ammonium or an alkali metal and y ranges from 2 to 50. It also includes alkyl aryl ether sulfates of formula

R-ϕ-O-(ρ-O)_{y}-SO₃X

wherein R is C₄-C₂₀ alkyl (in general, R is n-octyl or n-nonyl), ϕ is p-phenylene, p is C₂-C₁₀ alkylene (for example -CH₂-CH₂-, -CH₂-CH₂-CH₂-or a mixture thereof), X is ammonium or an alkali metal and y ranges from 2 to 50. Similar alkyl aryl ether are obtained by replacing R-ϕ in the above formula by [1,3-5-tri-(t-butyl)]-phenyl.

A fifth subclass of ionic emulsifiers of interest in accordance with the present invention lies in alkoxylated sulfosuccinates, such as the alkoxylated sulfosuccinates of formula

R-O-(ρ-O)_{y}-C(=O)-CH₂-CH(SO₃X)-C(=O)OX'

wherein R is C₈-C₂₀ alkyl, p is C₂-C₁₀ alkylene (for example -CH₂-CH₂-, -CH₂-CH₂-CH₂- or a mixture thereof), X and X' are independently ammonium or an alkali metal and y ranges from 2 to 50.

A sixth subclass of ionic emulsifiers of interest in accordance with the present invention consists of alkoxylated phosphates (also known as ether phosphates). In monoalkyl and dialkyl ether phosphates of respective formulae

R-O-(ρ-O)_{y}-P(=O)-(OX)₂

and

[R-O-(ρ-O)_{y}]₂-P(=O)-OX,

wherein R is C₈-C₂₀ alkyl, p is C₂-C₁₀ alkylene (for example -CH₂-CH₂-, -CH₂-CH₂-CH₂- or a mixture thereof), X is ammonium or an alkali metal, y ranges from 2 to 50 and, in case of dialkyl ether phosphates, y may differ from one R-O-(ρ-O)_{y} moiety to another.

The ionic emulsifier can be a cationic emulsifier.

Then, a last subclass of ionic emulsifiers of interest in accordance with the present invention consists of alkoxylated quaternary ammonium salts.

Certain useful representatives thereof are represented by formula 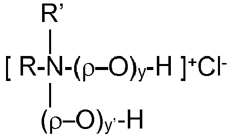 wherein R is C₈-C₂₀ alkyl or C₈-C₂₀ alkenyl, R' is C₁-C₂₀ alkyl or C₂-C₂₀ alkenyl, p is C₂-C₁₀ alkylene (for example -CH₂-CH₂-, -CH₂-CH₂-CH₂- or a mixture thereof), and y and y' independently range from 2 to 50.

The photoactive compositions of the present invention comprise a solvent system which is known to the skilled person for photoactive compositions of the type discussed.

The solvent system can be composed of one solvent. Useful solvents are e.g. halogenated benzenes, halogenated alkyl benzenes, alkyl benzenes, hydrogenated aromatic solvents, condensed aromatic compounds, which may be partly hydrogenated, halogenated hydrocarbons and thiophene derivatives or mixtures of these solvents, to name only a few examples. The solvent should in general have sufficiently low melting point to be liquid at room temperature on one hand and on the other hand boiling point sufficiently low to allow the drying of cast films in a reasonable time.

In a certain embodiment of the present invention, the solvent system consists of at least two solvents. The first solvent can be a solvent selected to dissolve solid components, in particular the n-type semiconducting material and/or the p-type semiconducting material. This solvent may e.g. be selected from an aromatic solvent, a halogenated aromatic solvent and by way of specific example chlorobenzene, 1,2-dichlorobenzene, trichloromethane, 1,2-dichloroethane, dichloromethane, carbon tetrachloride, toluene, xylene, cyclohexanone, ethyl acetate, cresol, butyrolactone and dimethylformamide or combinations thereof may be mentioned. In case of the p-type semiconducting material being based on a thiophene polymer, a second solvent may be used comprising at least one heterocyclic ring, preferably a thiophene ring. If more than one solvent is used their volume ratios may vary over a wide range, e.g. from 1:99 to 99:1, preferably of from 1:10 to 10:1. The skilled person will select the appropriate ratio based on the requirement of the specific situation based on his experience.

In a certain other embodiment of the present invention, the solvent system is composed of at least three solvents. Advantageously, said solvent system consists of at least one first solvent having a boiling point under atmospheric pressure of 130 °C or less, at least one second solvent having a boiling point under atmospheric pressure of more than 130 and up to 200 °C and at least one third solvent having a boiling point under atmospheric pressure of more than 200°C (hereinafter, "solvent system T"). Usually, the solvent system T is essentially free of any halogen containing solvent, and preferably is completely free of any halogen containing solvent. In accordance with other preferred embodiments, the solvents of the solvent system T are free of alkoxy or aryloxy groups and even more preferably the solvents of the solvent system T do not contain any oxygen atom in their molecular structure. The solvent system T may contain more than one solvent in each group of solvents with the different boiling point ranges.

In the solvent system T, preferred first solvents have a boiling point of less than 125 °C, particularly preferably of less than 120 °C. Exemplary solvents of this first group are toluene, pyridine, thiophene, thiazole, esters of alkanoic acids, in particular esters of C₁-C₅ alkanoic acids with C₁-C₄ alcohols, e.g. ethyl acetate, propyl acetate, butyl acetate, ethyl propionate, propyl propionate, methyl butyrate, ethyl butyrate or methyl pentanoate or dialkyl ethers like e.g. dipropyl ether, ethyl propyl ether, ethyl-tert. butyl ether and methyl-tert. butyl ether. Also suitable are carbocyclic solvents like e.g. cyclohexane or cycloheptane, which may be substituted or unsubstituted like e.g. methylcyclohexane or the like, dialkylketones with lower alkyl groups like e.g. methyl isobutyl ketone or linear alkanes like e.g. n-hexane, n-heptane or n-octane and the branched isomers thereof. Preferred solvents within the group of first solvents are those which have a boiling point of at least 80 °C as lower boiling solvents might evaporate too fast after the application of the composition which could detrimentally influence the properties of the product. Toluene is a particularly preferred solvent of the first group and has shown beneficial properties in certain cases. In accordance with a preferred embodiment, the at least one first solvent is selected from benzene derivatives and cycloalkane derivatives which may carry substituents or which may be unsubstituted. Preferred substituents are alkyl groups. The skilled person will select the suitable substituents taking into account the known boiling points of this group of compounds (the nature and number of the alkyl groups will increase the boiling point which might then exceed the limit of 130 °C in certain cases).

In the solvent system T, preferred solvents of the second group are selected from the group consisting of isomeric xylenes, the isomeric trimethyl benzenes, ethyl benzene, the isomeric propyl benzenes and the isomeric butyl benzenes. Furthermore, the C₁ to C₆ esters of C₃ to C₈ alkanoic acids like e.g. n-butyl propionate, propyl butyrate, butyl butyrate, isobutyl isobutyrate, ethyl pentanoate and propyl pentanoate, dialkylketones like methyl isoamylketone, methyl amyl ketone or ethyl amyl ketone and higher dialkyl ethers like e.g. dibutyl ether or propyl butyl ether may be mentioned. In accordance with a preferred embodiment, the solvents of this group, however, do not contain alkoxy or aryloxy groups and even more preferably the solvents of this group do not contain oxygen in their molecular structure at all. In certain cases the isomeric xylenes and in particular m-xylene have shown to provide beneficial properties to the final products.

In the solvent system T, the third group of solvents has a boiling point at atmospheric pressure of more than 200 °C, preferably of more than 205°C. Boiling points significantly exceeding 300°C, in particular exceeding more than 260°C, all under atmospheric pressure, are not normally preferred due to problems with evaporating same and also due to the fact that these solvents in a significant number of cases have melting points exceeding 23°C and in many cases exceeding 50°C, which is not preferred in accordance with the present invention. In this group the isomeric alkylated benzenes with alkyl groups comprising at least 5 carbon atoms, condensed ring systems comprising at least one aryl group and a cycloalkyl group annealed with the aryl group like e.g. tetralin, and unsubstituted cycloalkanes having at least 8 carbon atoms like cyclooctane and cyclononane, or substituted cycloalkanes with at least six carbon atoms in the ring and bearing alkyl substituents having at least six carbon atoms like e.g. hexylcyclohexane as well as alkylated aniline derivatives may be mentioned. Furthermore, aldehydes like salicylaldehyde or anisaldehyde may be mentioned. DMSO would be principally suitable; for environmental and health and safety reasons DMSO is not particularly preferred, however. From the foregoing those solvents free of alkoxy or aryloxy groups and in particular those solvents free of oxygen in their molecular structure are particularly preferred. Within this group, tetralin may be mentioned as preferred example.

Advantageously , the ternary solvent system T show a Newtonian behaviour or a shear thinning at higher shear rates (above 2000 to 3000 s⁻¹) than binary or single solvent systems.

The weight ratio of the solvents in the solvent mixture T is not subject to particular limitations and can thus be chosen within a wide range tailored to the specific needs of the application. According to a preferred embodiment of the present invention the solvent mixture comprises from 10% to 30% of at least one first solvent, from 40% to 80% of at least one second solvent and the remainder of at least one third solvent. All percentages relating to the ratio of the solvents are percentages by weight, based on the weight of the entire solvent system.

A particular preferred solvent system T in the compositions of the present invention is a ternary mixture of toluene, m-xylene and tetralin, in particular comprising of from 5 to 30 wt% of toluene, from 50 to 70 wt% of m-xylene and from 10 to 30% of tetralin.

Whatever the number of solvents in the solvent system (1, 2, 3 or more), the weight amount of the solvent system can be at least 5 times, at least 10 times, at least 20 times, at least 50 times or even at least 100 times higher than the weight amount of the organic semiconducting material (taken as a whole). Besides, the weight amount of the entire solvent system can be at most 2000 times, at most 1000 times, at most 500 times, at most 200 times or even at most 100 times higher than the weight amount of the organic semiconducting material (taken as a whole).

When the organic semiconducting material comprises at least one p-type semiconducting material, the weight amount of the solvent system can be at least 5 times, at least 10 times, at least 20 times, at least 50 times or even at least 100 times higher than the weight amount of the p-type semiconducting material. Besides, the weight amount of the entire solvent system can be at most 2000 times, at most 1000 times, at most 500 times, at most 200 times or even at most 100 times higher than the weight amount of the p-type semiconducting material.

The photoactive compositions of the present invention may comprise at least one p-type semiconducting material.

The p-type semiconducting material can be an organic material including a polymeric material, although other types of p-type semiconducting material are known in the art. For example, the p-type semiconducting material can comprise a conjugated polymer or a conducting polymer, comprising a polymer backbone having a series of conjugated double bonds. It can be a homopolymer or a copolymer including a block copolymer or a random copolymer, or a terpolymer. Examples include polythiophene, polypyrrole, polyaniline, polyfluorene, polyphenylene, polyphenylene vinylene, and derivatives, copolymers, and mixtures thereof. The p-type semiconducting material can comprise a conjugated polymer soluble or dispersible in organic solvent or water. Conjugated polymers are described in for example T. A. Skotheim, Handbook of Conducting Polymers, 3rd Ed. (two vol), 2007; Meijer et al., Materials Science and Engineering, 32 (2001}, 1-40; and Kim, Pure Appl. Chern., 74, 11, 2031-2044, 2002. The p-type active material can comprise a member of a family of similar polymers which have a common polymer backbone but are different in the derivatized side groups to tailor the properties of the polymer. For example, a polythiophene can be derivatized with alkyl side groups including e.g. methyl, ethyl, hexyl, dodecyl, and the like.

According to one embodiment copolymers and block copolymers which comprise, for example, a combination of conjugated and non-conjugated polymer segments, or a combination of a first type of conjugated segment and a second type of conjugated segment, may be used. For example these can be represented by AB or ABA or BAB systems wherein, for example, one block such as A is a conjugated block and another block such as B is an non-conjugated block or an insulating block. Or alternatively, each block A and B can be conjugated. If A & B are conjugated then A can be electron rich and B electron poor or A and B could both be electron rich. The non-conjugated or insulating block can be for example an organic polymer block, an inorganic polymer block, or a hybrid organic-inorganic polymer block including for example addition polymer block or condensation polymer block including for example thermoplastic types of polymers, polyolefins, polysilanes, polyesters, PET, and the like. Block copolymers are described in, for example, US Patent No. 6,602,974 and US Patent Publication No. 2006/0278867.

Facchetti, Chem.Mater. 2011, 733-758 provides in chapter 4 of his review an overview of suitable p-type polymers for use in photovoltaic applications of the type the present invention is aiming at. Reference may be made here to the structures provided on pages 749 et seq. and named P1 and P65-P88 the structures of which are given in Figs. 29, 31, 33 and 35 of this review article and which are incorporated herewith in their entirety.

Polythiophenes and derivatives represent a particularly preferred group of p-type semiconducting materials. They can be homopolymers or copolymers, including block copolymers and they can be soluble or dispersible. The polymers can be regioregular. A polymer is deemed to be regioregular if all the repeat units are derived from the same isomer of the monomer from which the polymer is produced (obviously regioregularity can only be described if there is more than one isomer of the monomer from which the polymer is formed). The degree of regioregularity thus describes the percentage of repeating units in the polymer chain derived from the same isomer of the monomer. Regioregular polythiophenes are as described in for example US Patent No. 6,602,974 and 6,166,172 to McCullough et al., as well as McCullough, R. D.; Tristram-Nagle, S.; Williams, S. P.; Lowe, R. D.; Jayaraman, M. J. Am. Chern. Soc. 1993, 115,4910, including homopolymers and block copolymers.

In particular, optionally substituted-alkoxy- and optionally substituted alkyl-polythiophenes can be used. Soluble alkyl- and alkoxy-substituted polymers and copolymers can be used including e.g. poly(3-hexylthiophene, P3HT). Other examples can be found in US Patent Nos. 5,294,372 and 5,401,537.

Additional examples of p-type semiconducting materials and polythiophenes can be found in WO 2007/011739 (Gaudiana et al.) which describes polymers having monomers which are, for example, substituted cyclopentadithiophene moieties.

In accordance with another embodiment the compositions of the present invention comprise a n-type semiconducting material.

In principle any n-type semiconducting material known to the skilled person as suitable for use in photovoltaic applications of the type contemplated with the compositions of the present invention may be used. Again, the review article of Facchetti referred to above discloses examples of suitable polymeric n-type semiconducting materials starting on page 754 and gives structures of some polymers of this type in Fig. 36 on page 754, which structures are reproduced below

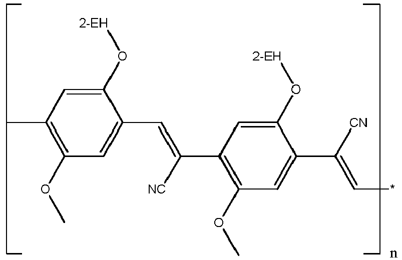

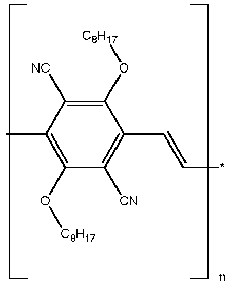

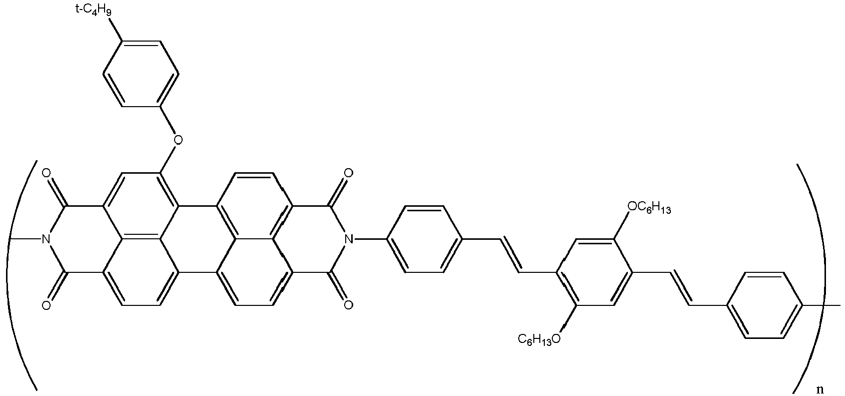

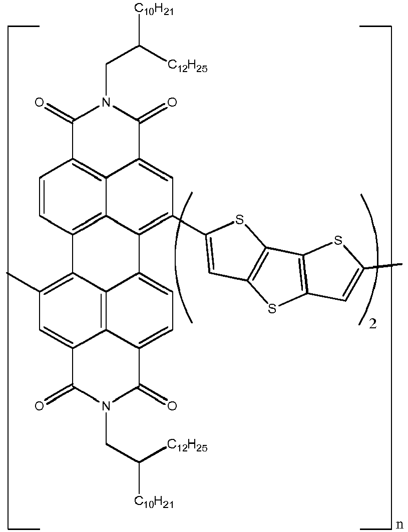

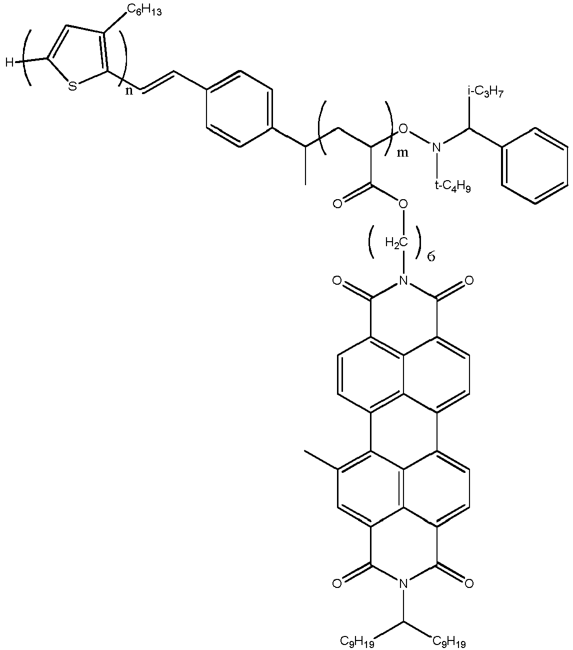

Preferred n-type semiconducting materials comprise a fullerene structure. Fullerenes are known in the art and can be described as spheroidal carbon compounds. For example, the fullerene surface can present [6,6] bonding and [6,5] bonding as known in the art. The fullerene can have a surface comprising six-membered and five-membered rings. Fullerenes can be for example C60, C70, or C84, and additional carbon atoms can be added via derivative groups. See for example Hirsch, A.; Brettreich, M., Fullerenes: Chemistry and Reactions, Wiley-VCH Verlag, Weinheim, 2005. This reference gives a broad teaching for fullerene nomenclature and synthesis, derivatization and reactions. Methods described t herein can be used to synthesize fullerene derivatives and adducts.

Derivatized fullerene or fullerene derivatives may also be used as n-type semiconducting materials in the compositions of the present invention. The derivative compound can be for example an adduct. The terms "derivatized fullerene,"and "fullerene derivative" as used herein, can be used interchangeably and can be for example fullerenes comprising, from 1 to 84, or 1 to 70, or 1 to 60, from 1 to 20, from 1 to 18, from one to ten, or from one to six, or from one to five, or from one to three substituents each covalently bonded to, for example, one or two carbons in the spheroidal carbon compounds. The derivatized fullerene can comprise a fullerene covalently bonded by [4+2] cycloaddition to at least one derivative moiety, R.

Structures for the n-type semiconducting material can be represented by F*-(R)ₙ and solvates, salts or mixtures thereof, wherein
n is at least one,
F is a spheroidal fullerene having a surface which comprises six-membered and five-membered rings; and R comprises at least one optionally substituted, unsaturated or saturated, carbocyclic or heterocyclic first ring, wherein the first ring directly bonds to the fullerene.

The following formula represents an embodiment of a C60-fullerene wherein C60 is bonded to n R groups, the bonding being generically presented:

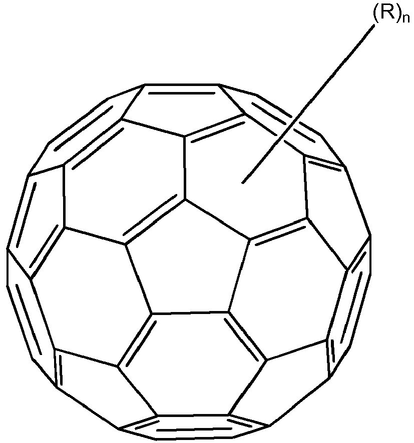

The first ring can be substituted or unsubstituted and saturated or unsaturated. The first ring can be a carbocyclic or a heterocyclic ring. Examples are optionally substituted four-membered, five-membered, or six-membered rings, in particular optionally substituted five-membered ring.

The R group can further comprise a second ring which is bonded to or fused with the first ring. The second ring can be optionally substituted. The second ring can be for example an aryl group which is fused to the first rings.

The first ring directly bonds to the fullerene. For example, the R group can covalently bond to the fullerene by a [4+2] cycloaddition. The R group can be covalently bonded to the fullerene by one or two covalent bonds, including two covalent bonds, including by two carbon- carbon bonds. The R group can be bonded to the fullerene surface by a covalent bond to one atom in the R group. Alternatively the R group can be bonded to the fullerene surface by covalent bonds to two atoms in the R group. The two atoms in the R group bonded to the fullerene can be adjacent to each other, or can be separated by from each other by 1 to 3 other atoms in the R group. The R group can be covalently bonded to the fullerene by two carbon- carbon bonds at a fullerene [6,6] position.

The fullerene can comprise only carbon atoms or one or more of the carbon atoms may be replaced by heteroatoms. The fullerene can comprise at least one other derivative group bonded to the fullerene besides R.

For example, fullerenes can be derivatized with electron withdrawing groups or electron donating groups. Electron withdrawing groups and electron donating groups are known in the art and can be found in Advanced Organic Chemistry, 5th Ed, by Smith, March, 2001.

The electron withdrawing group can be attached directly to the fullerene cage or via methano-bridges similar to the PCBM structure.

The electron donating group can be attached directly to the fullerene cage or via methano-bridges similar to the PCBM structure.

Fullerenes can be derivatized to improve their absorption in the visible range, relative to C60-PCBM. Improved absorption in the visible range may increase or improve the photocurrent of a photovoltaic device comprising the derivatized fullerene.

In one embodiment, F* is selected from C60, C70 and C84, and combinations thereof. In one embodiment, R is selected from optionally substituted aryl and optionally substituted heteroaryl.

In another embodiment, R is selected from optionally substituted indene, optionally substituted naphthyl, optionally substituted phenyl, optionally substituted pyridinyl, optionally substituted quinolinyl, optionally substituted cyclohexyl, and optionally substituted cyclopentyl.

In still another embodiment R is selected from indene, naphthyl, phenyl, pyridinyl, quinolinyl, cyclohexyl and cyclopentyl.

The value n can be an integer. In one embodiment, n can be from 1 to 84, or from 1 to 70, or from 1 to 60, or from 1 to 30, or from 1 to 10. In one embodiment n is from 1 to 6. In another embodiment n is from 1 to 3 and in still another embodiments n is 1. 2 or 3.

The first ring can be optionally substituted with at least one substituent selected from the group consisting of hydroxy, acyl, acylamino, acyloxy, alkyl, substituted alkyl, alkoxy, substituted alkoxy, alkenyl, substituted alkenyl, alkynyl, substituted alkynyl, amino, substituted amino, aminoacyl, aryl, substituted aryl, aryloxy, substituted aryloxy, cycloalkoxy, substituted cycloalkoxy, carboxyl, carboxyl esters, cyano, thiol, thioalkyl, substituted thioalkyl, thioaryl, substituted thioaryl, thioheteroaryl, substituted thioheteroaryl, thiocycloalkyl, substituted thiocycloalkyl, thioheterocyclic, substituted thioheterocyclic, cycloalkyl, substituted cycloalkyl, halo, nitro, heteroaryl, substituted heteroaryl, heterocyclic, substituted heterocyclic, heteroaryloxy, substituted heteroaryloxy, heterocyclyloxy, or substituted heterocyclyloxy, or combination thereof.

In a preferred embodiment n is 1, 2, 3, 4, 5, 6 and R is indene

In another preferred embodiment, R can be covalently bonded to the fullerene by [4+2] cycloaddition, alternatively called a [4+2] cycloadduct. Reactions including [4+2] cycloaddition reactions and Diels-Alder reactions are generally known in the art. A dienophile double bond can react with a diene to produce a six membered ring. See for example Advanced Organic Chemistry, Reactions, Mechanisms. and Structure, 2nd Ed., J. March, r977, including chapters on addition to carbon-carbon multiple bonds (e.g., Chapter 15). See also, Belik et al., Angew. Chern. Int. Ed. Engl. 1993, 32, 1, 78-80 (showing reaction of C60 with a C8 o-quinodimethane compound to form a C68 compound comprising the fullerene and the derivative moiety); and Puplovskis et al.,Tetrahedron Letters, 38, 2, 285-288, 1997,285-288 (showing reaction of C60 with C9 indene to form a C69 compound comprising the fullerene and the derivative moiety). The cycloaddition reaction can result in reaction at the [6,6] fullerene double bonds rather than [6,5] double bonds. Cycloaddition reactions are described in detail in Chapter 4, pages 101-183, of Hirsch, Brettreich, Fullerenes, Chemistry and Reactions, 2005.

One example of a fullerene derivative is an indene derivative. In addition, indene itself can be derivatized. Fullerene can be derivatized by methods described in for example Belik et al., Angew. Chern. Int. Ed. Engl., 1993, 32, No. 1, pages 78-80. This paper describes addition to electron poor superalkene, C60, which can add radicals such as o-quinodimethane. It can be prepared in situ containing different functional groups and form very reactive dienes that can form [4 + 2] cycloadducts even with the least reactive dienophiles. This method provides good selectivity and stability.

The fullerene can comprise at least two derivative moieties, R, to form bis-adducts or at least three derivative moieties, R, to form tris-adducts. These substituents can be added to the fullerene by [4+2] cycloaddition. For example, Belik et al. show in Scheme 1, formula 3, a fullerene compound comprising two derivative moieties. In addition, two fullerenes can be covalently linked by one derivative moiety as shown in Scheme 2 of Belik et al.

While the various embodiments are not limited by theory, it is believed that the derivatization may disrupt the conjugation of the fullerene cage. Disrupting the conjugation effects the ionization potential and electron affinity of the derivatized fullerene.

In accordance with still another embodiment the compositions of the present invention comprise a p-type semiconducting material and a n-type semiconducting material wherein the materials may be selected preferably from those described hereinabove.

In accordance with a preferred embodiment, a combination of poly-3-hexyl-thiophene (P3HT) and the phenyl-C61-butyric acid methyl ester (PCBM) or the indene bis adduct of fullerene (ICBA) is used.

If both a p-type semiconducting material and a n-type semiconducting material is present, the weight ratio of these components usually is within the range of from 1:10 to 10:1, preferably in the range of from 4:1 to 1:4. In some cases a mixture of P3HT:PCBM in the range of from 2:1 to 1:2, in particular approximately 1.25:1 has been shown to lead to good results. Advantageously the concentration is chosen so that the compositions can be used at room temperature for printing or coating in accordance with known methods without the need to heat the compositions prior to their use as is often required with the compositions of the prior art which often have a gel-like consistency at room temperature.

The amount of p-type semiconducting material and n-type semiconducting material or the mixtures thereof in the compositions of the present invention is not subject to specific limitations and may generally be in the range of from 0.1 to 10, preferably of from 0.3 to 5 wt% and most preferably in the range of from 0.5 to 4 wt%, based on the weight of the composition.

The compositions of the present invention can advantageously be used in the manufacture of photovoltaic devices and the devices obtained using the compositions of the present invention show a good combination of stability and performance.

The compositions of the present invention can be used in any known process for the manufacture of such devices, i.e. there are no limitations or restrictions in this regard.

A particularly valuable aspect of the present invention lies in a photovoltaic device comprising at least one photoactive layer formed from the photoactive compositions as above described.

Devices using the presently claimed invention can be made using for example ITO as an anode material on a substrate. Other anode materials can include for example metals, such as Au, carbon nanotubes (single or multiwalled), and other transparent conducting oxides. The substrate can be for example glass, plastics (PTFE, polysiloxanes, thermoplastics, PET, PEN and the like), metals (Al, Au, Ag), metal foils, metal oxides, (TiOx, ZnOx) and semiconductors, such as Si. The ITO on the substrate can be cleaned using techniques known in the art prior to device layer deposition. An optional hole injection layer (HIL) can be added using for example spin casting, ink jetting, doctor blading, spray casting, dip coating, vapour depositing, or any other known deposition method. The HIL can be for example PEDOT, PEDOT/PSS or TBD, or NPB.

The photoactive layer, which can be formed from the invented compositions, can be then deposited by spin casting, ink jetting, doctor blading, spray casting, dip coating, vapour depositing, or any other known deposition method, on top of the HIL film. The film is then optionally annealed at for example about 40 to about 250 °C, or from about 150 to 180 °C, for about 10 min to an hour in an inert atmosphere.

Next, a cathode layer can be added to the device, generally using for example thermal evaporation of one or more metals. For example, a 1 to 15 nm Ca layer is thermally evaporated onto the photoactive layer through a shadow mask, followed by deposition of a 10 to 300 nm Al layer or silver.

In some embodiments and optional interlayer may be included between the photoactive layer and the cathode, and/or between the HTL and the photoactive layer. This interlayer can be for example from 0.5 nm to about 100 nm, or from about 1 to 3 nm, thick. The interlayer can comprise an electron conditioning, a hole blocking, or an extraction material such as LiF, BCP, bathocuprine, fullerenes or fullerene derivatives, such as C60 and other fullerenes and fullerene derivatives discussed herein.

The devices can be then encapsulated using a glass cover slip sealed with a curable glue, or in other epoxy or plastic coatings. Cavity glass with a getter/dessicant may also be used.

### Example

A composition in accordance with the present invention is obtained by weighing bis -PC[60]BM having the formula 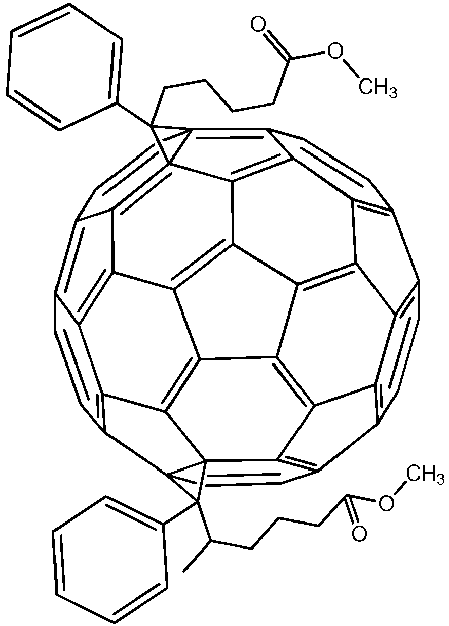 and P3HT polymer with a metal trace content of less than 0.1 %, a molecular weight of approximately 50,000 D and a regioregularity of more than 91 % in a weight ratio of 0.8 to 1 to yield a solids concentration of 3 wt% in tetralin. This solution is stirred overnight and thereafter 1 wt% of a an organic substance (S) containing at least two C₂-C₁₀ oxyalkylene moieties and differing from an oxyalkylene-containing sorbitan ester (as previously described) is added to the solution, and the solution is stirred for two days. Thereafter the solution is put on a hot plate at 60 °C for 30 minutes, cooled and thereafter the solution is diluted with toluene to arrive at a final concentration of 20 % toluene. The composition is stored under Ar and is let to sit for at least one day.

A comparative composition is obtained without the addition of the organic substance (S).

Rheology measurements are performed using an ArR1500 Rheometer (TA Instruments) fitted with a 60 mm parallel plate geometry. Due to low viscosities, the air bearing friction correction factor is enabled and a geometry gap of 500 microns is utilized. Measurements entail an equilibrium step lasting two minutes followed by a flow experiment whereby shear rate is increased from 50 to 9000 s⁻¹ using a steady state regime. Equilibrium flow is obtained for each data point within a period of sixty seconds. All measurements are carried out at 40 °C.

The flow curves for the comparative composition exhibit desired shear thinning at shear rates up to about 2000 s⁻¹ whereas the composition in accordance with the present invention exhibits shear thinning up to shear rates of about 6000 s⁻¹ which constitutes a significant advantage in the processing out of solution.

## Claims

1. Photoactive composition comprising an organic semiconducting material consisting of either (i) at least one p-type semiconducting material or (ii) at least one n-type semiconducting material or (iii) at least one p-type semiconducting material and at least one n-type semiconducting material in a solvent system, wherein the composition contains at least one organic substance (S) containing at least two C₂-C₁₀ oxyalkylene moieties other than a sorbitan ester.

2. Photoactive composition according to claim 1, wherein the oxyalkylene moieties are oxyethylene moieties.

3. Photoactive composition according to claim 1 or 2, wherein the substance (S) is a polymer essentially all or all the repeating units of which comply with general formula -p-O- wherein p represents a divalent alkylene group having from 2 to 10 carbon atoms.

4. Photoactive composition according to claim 1 or 2, wherein the substance (S) is a non ionic emulsifier.

5. Photoactive composition according to claim 3, wherein the substance (S) is an alkoxylated alcohol.

6. Photoactive composition according to claim 3, wherein the substance (S) is an alkoxylated acid.

7. Photoactive composition according to claim 3, wherein the substance (S) is an alkoxylated amine or an alkoxylated alkanolamide.

8. Photoactive composition according to claim 3, wherein the substance (S) is a fluorosurfactant.

9. Photoactive composition according to claim 1 or 2, wherein the substance (S) is an anionic emulsifier.

10. Photoactive composition according to claim 9, wherein the substance (S) is an alkoxylated sulfate.

11. Photoactive composition according to claim 9, wherein the substance (S) is an alkoxylated sulfonate or an alkoxylated sulfosuccinate.

12. Photoactive composition according to claim 1 or 2, wherein the substance (S) is a cationic emulsifier, in particular an alkoxylated quaternary ammonium salt.

13. Photoactive composition in accordance with any one of the preceding claims wherein the organic semiconducting material consists of at least one n-type semiconducting material and at least one p-type semiconducting material.

14. Photoactive composition in accordance with claim 13 wherein the n-type semiconducting material is a fullerene or a fullerene derivative and the p-type semiconducting material is a polythiophene or polythiophene derivative.

15. Photovoltaic device comprising at least one photoactive layer formed from the photoactive composition in accordance with any of the preceding claims.
